# EUROPEAN PATENT APPLICATION

(11) **EP 0 550 389 A1**
(43) Date of publication of application: **07.07.1993**
(21) Application number: 92830629.9
(22) Date of filing: 20.11.1992
(51) Int. Cl.: G01R 31/36

(54) **A device for detecting the condition of batteries, particularly on board motor vehicles**

(30) Priority: 02.12.1991 IT TO910936
(71) Applicant: FIAT AUTO S.p.A., I-10135 Torino (IT)
(72) Inventor: Malvicino, Carloandrea, I-10146 Torino (IT); Cisternino, Maurizio, I-10132 Torino (IT)
(74) Representative: Bosotti, Luciano

(57) **Abstract**

A battery condition test is effected by connecting the battery (K) to a stable load of predetermined value - typically a resistor (1) - for a short time interval, typically of the order of one second. The voltage (Vb) thus appearing across the terminals of the battery (K) of the test under load is transferred to two threshold elements (9,10) with respective different threshold voltage levels (A,B).

Different indicator elements such as, for example, a yellow LED (12) and a red LED (15) are activated when the battery voltage level (B) reaches, respectively, the said first (A) and the said second (B) level, lower than the first. The user is thus provided with two indications, respectively an alerting indication and an alarm indication relating to the condition of the battery.

## Description

The present invention deals in general with the problem of detecting the condition of batteries, such as electrochemical accumulator batteries which may be mounted on board motor vehicles or may be stationary.

The purpose of the invention is essentially that of providing a battery-condition detector device capable of being installed on-board a motor vehicle without particular fitting problems and with low industrialisation costs.

According to the present invention this object is achieved by a device having the characteristics set out in a specific manner in the claims which follow.

The invention will now be described, purely by way of non-limitative example, with reference to the attached drawings, in which:

Figure 1 is a diagram useful for an understanding of the operating principal of the invention; and

Figure 2 illustrates in the form of a block schematic diagram, the general structure of the device according to the invention.

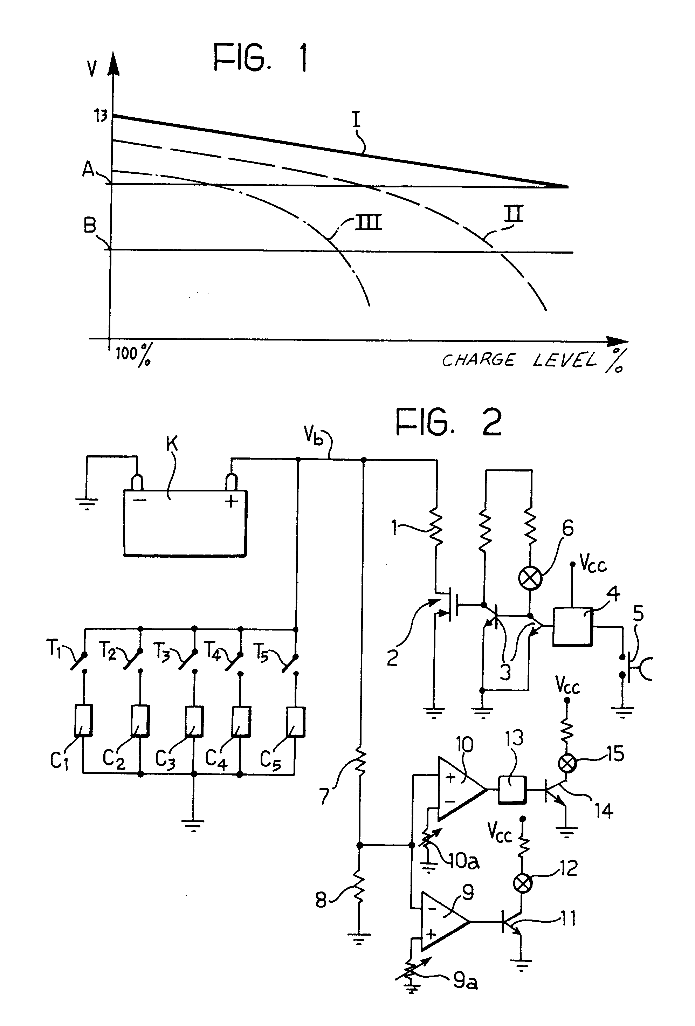

The diagram of Figure 1 illustrates (along the ordinate), in dependence on the percentage charge level (in AMP- hours (Ah) plotted on the abscissa) the typical variation of voltage V detectable across the terminals of a battery, such as an electrochemical accumulator battery of the type currently installed on motor vehicles.

It can be observed how, starting from the maximum charge level (100%, constituting, however, an ideal condition) in which the voltage assumes a maximum value, the voltage gradually decreases as the charge level falls.

In particular, the curve in solid outline indicated I shows a typical open circuit voltage which can be detected across the terminals of the battery, that is to say without there being any delivery of current into a load.

The two curves II (in broken outline) and III (in dot and dash line) on the other hand refer to a typical behaviour which can be detected under load, that is to say by measuring the voltage across the battery terminals when it delivers current into a load.

The curve II illustrates a typical variation encountered in a battery, which independently of the charge level, can be considered generally to be in good condition.

The curve III illustrates, on the other hand, the typical variation encountered with a battery in poor condition, such as, for example, a battery which has been in use for a long period of time or a battery which has not been used for a long time so that layers of material which obstruct the delivery of the charge from the battery itself have formed on the electrode plates of its elements.

Again, from Figure 1, it can be noted that, whilst the curve 1 has a practically constant slope (at least in the range of charge levels of effective interest) both the curves II and III under load demonstrate a typical 'knee' type variation in the sense that the voltage available at the battery terminals tends to decrease more rapidly once the charge has fallen below a certain charge level limit.

For this reason the detection ot the open circuit battery voltage (that is to say with reference to curve I) gives a very poor indication of the effective charge state and condition of the battery.

On the contrary, the curves under load (II and III) as well as being very much more representative of the effective capacity of the battery to deliver energy and electrical power, can also be used to effect a detection (and therefore an indication for the user) with a certain predictive character so as to warn the user that, even though the battery condition is at present sufficient, it is now at this point approximating to the conditions in which the battery will no longer be in a condition to ensure the levels of electrical energy delivery which will be required. Such a predictive indication is very useful, especially in relation to the activation of the vehicle's electric starter motor which, whilst being actuated only for very short intervals of time, constitutes a load which can draw very significant current (of the order of 200A).

It has already been proposed in the past (see for example Italian Patent 1159568) to provide, on board a motor vehicle, detection of the charge state of a battery whilst it is under load, that is to say whilst the battery is delivering current to utiliser apparatus situated on board the motor vehicle (typically the starter motor). In practice this solution faces difficulty due to the fact that utiliser apparatus situated on board a motor vehicle constitute loads with widely variable characteristics both in dependence on the different climatic conditions and due to the effect of changes over time, as well as by the effect of statistical variations in the parameters from apparatus to apparatus as well as from vehicle to vehicle.

Therefore the possibility of obtaining entirely reliable detection and indication is not available other than through complex calibration and adjustment operations which are usually not achievable on a vehicle in current conditions of use.

The present invention obviates this disadvantage by utilising, as a specimen load to connect to the battery for detection of the charge state, a suitable load (typically a power resister) the characteristics of which are precisely determined and stable and are therefore not subject to particular drift and variation phenomena.

As well as this, in the arrangement according to the invention, the act of detection is performed by comparing the voltage across the battery terminals with two threshold levels indicated A and B in Figure 1) the first slightly greater than the second.

For example, with reference to a normal battery mounted on a motor vehicle (in which the detectable voltage level across the terminals of a fully charged battery in good condition reaches the limit value of 13 volts), the two levels A and B can be chosen, respectively, in the region of 11.8 volts and 11 volts. Experiments conducted by the applicant have shown that these levels make it possible to effect a dual action of detection and indication of an alerting nature (when the battery voltage reaches the higher level, indicated A) and of an alarm nature (when the battery voltage reaches the lower level B).

In this way the motor vehicle driver, by connecting the said known load to the battery to conduct of a test, is not only advised of the fact that the charge state of the battery is at this point dangerously low (alarm indication) but, before this occurs, he is advised (alerting signal) of the fact that the battery condition is starting to become insufficient, inviting him to put into effect appropriate remedial measures.

In a currently preferred embodiment the device according to the invention assumes the configuration illustrated in Figure 2.

In this Figure, the reference numeral K generally indicates a battery the condition of which it is desired to detect. This may be for example, an electrochemical accumulator battery mounted on board a motor vehicle driven by an internal combustion engine. Alternatively, it could be one of the batteries of an electrically driven motor vehicle power pack. Again, it could be a battery mounted on a vehicle of different type such as a railway vehicle, an earth moving vehicle or a heavy transport vehicle, or even a stationary battery such as, for example, those employed in telephony.

Naturally, in dependence on the application, the nominal voltage of a fully charged battery may vary from the 13 volt level indicated above, and could, for example be about 6 volts or about 24 volts. Naturally, it remains understood that the device of the invention can easily be applied also to such particular detection conditions by modifying the threshold levels A and B of Figure 1 in a corresponding manner. The reference numerals C1 to C5 schematically indicate various electric utiliser devices in Figure 2 (starter motor, lights, heated window, cigar lighter, car radio etc) situated on board the motor vehicle and capable of being connected to the battery K through respective switches T1 to T5. The reference numeral 1 indicates a resistor of known value (typically 0.68 Ohms) which can be selectively connected between the positive terminal of the battery K and the earth of the vehicle's electrical system through a switch constituted for example by a solid state switch such as a power transistor (for example an IRF 640 transistor). The gate of this transistor is controlled through one or more transistorised stages 3, by a monostable circuit (for example an NE 555 flip-flop) to which is connected an actuating push button 5 which can be pressed by the driver to perform a test on the condition of the battery K.

Preferably an indicator such as an LED 6, is connected to one of the amplifier stages 3.

The connection configuration is such that when the driver pushes the push button 5 the monostable circuit 4 controls the transistor 2 to conduct for a predetermined time interval (about 1 second) with the consequential connection of resistor 1 between the battery voltage Vb and the circuit earth. During this interval the LED 6 (for example a green LED) illuminates to indicate to the driver that the test is being conducted, and the duration thereof.

The battery voltage Vb itself (which during performance of the above described test corresponds to the battery voltage under load, the battery K in fact delivering to the resistor 1 a current of the order of about 13-17 amps, depending on the charge state of the battery) is transferred, through a voltage divider constituted by two resisters 7 and 8 to a twin threshold circuit. This circuit comprises, for example, two operational amplifiers 9,10 (for example 2LM 2903) configured as hysteresis free threshold comparators the threshold level of which can be selectively adjusted by acting on corresponding resistors 9a and 10a.

In particular, the threshold of the first comparator 9 defines the upper comparison level indicated A in Figure 1. The same comparator circuit directly controls, for example via a transistor 11, a first illuminable indicator constituted for example by a yellow LED 12 situated in a position clearly visible to the driver.

In a substantially similar way the comparator 10, the threshold level of which is adjusted in a manner so as to correspond to the lower level indicated B in Figure 1, controls, via a further monostable circuit 13 (with an activation time for example of the order of 5 seconds) and a transistor 14, a further indicator 15 constituted for example by a red LED also connected in a position visible to the driver.

It will be noted, that for reasons of control of the monostable 13, the connection arrangement of the threshold comparator 10 is opposite that of the threshold comparator 9. The battery voltage Vb is in fact applied to the non-inverting input of the comparator 9 and the inverting input of the comparator 10, respectively. This deals with a single circuit aspect: the operating criteria of the two threshold comparators are, in fact, substantially identical to one another as far as the detection action is concerned.

It will likewise be appreciated that the active circuits of the detector device (and in particular the a stable circuits 4 and 13, the threshold comparators 9 and 10 and the LED 12 and 15) are connected to a stabilised voltage Vcc having, for example, a value of 6V and are not directly connected to the battery voltage Vb: all this is to prevent variations of this latter having a too- direct influence on the operation of the detector device.

During performance of the test conducted by pressing the push button 5 (the performance and duration of which are indicated by illumination of the green LED 6) the voltage Vb present across the terminals of the battery K (which delivers current into the specimen load constituted by the resistor 1) is taken to the input of the threshold comparators 9 and 10 and compared with the threshold levels A, B (for example 11.8V and 11V respectively) set therein.

There are three possible operating conditions which can be encountered.

The first is that which arises when the battery voltage Vb remains above both the threshold levels A, B: in this case neither the LED 12 nor the LED 15 is activated.

The second condition arises when the voltage Vb is lower than the level A but still above the level B. In this case the yellow LED 12 is illuminated and remains illuminated as long as the voltage across the terminals is greater than the threshold. Thus an alerting signal is sent to the driver, indicative of the fact that the battery charge state, whilst still being satisfactory, will soon become insufficient. The driver is now alerted to the necessity of intervening in this respect.

The third condition arises when the battery voltage Vb is lower than both the level A and the level B. In this case both the yellow LED 12 and, for a time interval (for example 5 seconds) corresponding to the hold interval of the hold monostable 13 - the red LED 15 are activated. Thus the driver is sent a signal indicative of the fact that the battery charge state is now becoming insufficient or has already become insufficient, thus indicating to the driver the necessity of proceeding with the maximum urgency to perform a recharging operation.

From observation of the diagram of Figure 2 it will be noted that the detection unit constituted by the threshold comparators 9 and 10 is in any case sensitive to the battery voltage even when the resistor 1 is not connected to the battery K. In particular the threshold comparators 9 and 10 are able to detect the voltage present across the battery terminals when this is providing current to one or more of the loads C1...C5.

This occurs, in particular, when the battery B supplies the starter motor, which certainly constitutes the load having the greatest power consumption. Thus, during the operation of the starter motor, the driver will have a way of being alerted to the fact that the charge state of the battery is falling (illumination of the yellow LED 12) or has already become insufficient (illumination of both the LEDs 12 and 15). All this takes place before the condition of total discharges of the battery K at least as far as the performance of a starting operation on an internal combustion engine in normal working conditions is concerned. The applicant has had reason to test experimentally the correctness of the information provided by a device according to the invention on batteries K of the type mounted on currently produced motor vehicles.

In particular, two lead-acid batteries of 55 Ah and 45 Ah of which the first was in an extended wear condition were brought to different charge states. The batteries were then mounted on a Lancia Dedra 1600 motor car to evaluate the effectiveness of its starting. In these conditions voltage/charge level curves were detected with a variation substantially corresponding to that of the curves II and II of Figure 1.

The device according to the invention has made it possible to detect without ambiguity (by use of the threshold levels equal to 11.8v and 11v indicated hereinabove), the degradation of the efficiency, and in any event the performance, of the battery which takes place in both cases when the residual charge available is equal to about 10 Ah.

For both the batteries considered the device according to the invention allowed an alerting diagnosis (illumination of the yellow LED 12) when the available charge is about 20 Ah and an alarm diagnosis (illumination of the red LED 15 as well) when the available charge amounts to about 7 Ah and the battery is therefore still able to effect starting of an internal combustion engine in good working order.

The influence of temperature is automatically taken into account by the test, considering in fact that a reduction in the temperature degrades the performance of the accumulator when the voltage during the measurement falls, no matter how, below the alerting or alarm thresholds identified hereinabove.

The device further provides an indirect diagnosis of the wear state of the battery. A new battery in fact delivers during normal use on a motor vehicle the major part of its rated deliverable charge. On the other hand, if the battery is worn, it is sufficient that it should deliver a small charge for the purpose that the device according to the invention may diagnose the alerting state (illumination of the yellow LED 12). Therefore the driver who, by performing the measurement after normal use of the motor vehicle, observes the illumination of the yellow LED 12, will know not only that the battery is no longer charged, but also that probably it is worn. Naturally, the principal of the invention remaining the same, the details of the construction and embodiments can be widely varied with respect to what has been described and illustrated, without by this departing from the ambit of the present invention.

## Claims

1. A device for detecting the condition of an electric battery (K), characterised by the fact that it comprises:
- an electric load (1) of stable predetermined value,
- switch means (2) for selectively connecting the said electric load (1) to the said battery (K) to perform a battery condition test, and
- voltage detector means (9,10) for detecting the voltage level (A,B) present across the terminals of the battery (K) during performance of the said test; the said voltage detector means comprising at least one threshold element (9,10) for identifying a condition in which the said voltage (Vb) across the battery terminals reaches at least a respective threshold level (A,B) in order to cause activation of at least one associated indictor element (12,15).

2. A device for detecting the condition of an electric battery (K) characterised by the fact that it comprises:
- a first (9) and a second (10) threshold detector having a respective first (A) and second (B) threshold level, sensitive to the voltage (Vb) across the terminals of the said battery (K) during a battery condition test; the said first (9) and second (10) threshold detector being associated with respective indicator elements (12,15) adapted to be activated to emit corresponding warning (12) and alarm (15) indications relating to the condition of the said battery (K) when the voltage (Vb) across the terminals of the said battery (K) reaches, respectively, the said first (A) and second (B) threshold level.

3. A device for detecting the condition of a battery (K) having the characteristics of Claims 1 and 2 taken in combination with one another.

4. A device according to Claim 1 or Claim 3, characterised by the fact that the said switch means (2,4,5) are arranged for connecting said pre-determined load (1) to the said battery (K) for an interval of given duration.

5. A device according to Claim 4, characterised by the fact that the said interval has a duration of the order of about 1 second.

6. A device according to any of Claims 1 or 3 to 5, characterised by the fact that the said switch means comprise an electronic switch (2).

7. A device according to Claim 6, characterised by the fact that the said electronic switch is a transistor (2).

8. A device according to Claim 4, characterised by the fact that the said switch means (2) is associated with a stable circuit (4) to connect the said predetermined load (1) to the said battery (K) for the said given time interval.

9. A device according to any of Claims 1 and 3 to 7, characterised by the fact that the said switch means (2) is associated with an indicator element (6) capable of being activated during the said test.

10. A device according to Claim 9, characterised by the fact that the said indicator element is a visual indicator element.

11. A device according to Claim 10, characterised by the fact that the said indicator is an LED (6).

12. A device according to Claim 2 or Claim 3, characterised by the fact that the said first (9) and second (10) threshold detector comprise operational amplifiers.

13. A device according to Claim 2 or Claim 3, characterised by the fact that the said respective indicator elements are visual indicator elements (12,13).

14. A device according to Claim 13, characterised by the fact that the said respective indicator elements are LEDs (12,15).

15. A device according to Claim 13 or Claim 14, characterised by the fact that the said visual indicator elements (12,15) are a different colour from one another.

16. A device according to Claim 2 or 3, characterised by the fact that the said first threshold detector (9) is associated with an indicator element (12) which is maintained in activated condition for as long as the battery voltage (Vb) across the terminals of the said battery (K) remains below the respective first threshold level (A).

17. A device according to Claim 2 or 3, characterised by the fact that the said second threshold detector (10) has associated therewith a respective indicator (15) element with interposition of timer means (13) which cause activation of the said second indicator (15) for an associated time interval when the said voltage (Vb) across the terminals of the battery (K) reaches the said second threshold level (B).

18. A device according to Claim 17, characterised by the fact that the said respective time interval has a duration in the order of five seconds.

19. A device according to Claim 2, characterised by the fact that the said first (9) and the said second (10) threshold detectors are connected to the terminals of the battery (K) in a substantially continuous manner so that the said threshold detectors (9,10) are in any event sensitive to the voltage level present across the terminals of the said battery (K) in a manner independant of the load (C1 to C5) possibly connected to the battery itself.

20. A device according to Claim 2 or 3, characterised by the fact that the said first (A) and the said second (B) threshold level are set, respectively, in the region of 11.8 and 11 volts.

21. A device according to Claim 1, characterised by the fact that the said stable load of predetermined value is a resistor (1).

22. A device according to Claim 21, characterised by the fact that the said resistor has a resistance value not greater than about 1 Ohm, typically 0.75 Ohm.
